# FASCICULE DE BREVET EUROPEEN

(11) **EP 2 572 382 B1**
(45) Date de publication et mention de la délivrance du brevet: **25.03.2015**
(21) Numéro de dépôt: 11717657.8
(22) Date de dépôt: 05.05.2011
(51) Int. Cl.: H01L 27/148

(54) **CAPTEUR D'IMAGE MATRICIEL A TRANSFERT DE CHARGES A GRILLE DISSYMETRIQUE**
MATRIX-LADUNGSÜBETRAGUNGSBILDSENSOR MIT ASYMMETRISCHEM GATE
MATRIX CHARGE-TRANSFER IMAGE SENSOR WITH ASYMMETRIC GATE

(30) Priorité: 18.05.2010 FR 1002086
(43) Date de publication de la demande: 27.03.2013
(73) Titulaire: E2V Semiconductors, 38120 Saint Egrève (FR)
(72) Inventeur: MAYER, Frédéric, F-38500 Voiron (FR); BELL, Ray, HA7 3PQ Stanmore, Middx (GB)
(74) Mandataire: Guérin, Michel
(86) Numéro de dépôt international: PCT/EP2011/057243
(87) Numéro de publication internationale: WO 2011/144459

(56) Documents cités:
- WO-A2-2006/073875
- US-A- 4 779 124
- US-A- 5 134 087
- US-B1- 6 465 820

## Description

L'invention concerne les capteurs d'image, tout particulièrement mais non exclusivement les capteurs à défilement et intégration de signal (ou capteurs TDI, de l'anglais : "Time Delay Integration" Linear Sensors"), dans lesquels une image d'une ligne de points d'une scène observée est reconstituée par addition d'images successives prises par plusieurs lignes photosensibles observant successivement une même ligne de la scène au fur et à mesure que la scène défile devant le capteur perpendiculairement aux lignes.

Ces capteurs sont utilisés par exemple dans des systèmes d'observation de la terre par satellite. Ils comprennent plusieurs lignes parallèles de pixels photosensibles ; le séquencement des circuits de commande des différentes lignes (contrôle de temps d'exposition puis de lecture des charges photogénérées) est synchronisé par rapport au défilement relatif de la scène et du capteur, de manière que toutes les lignes du capteur voient une seule ligne de la scène observée. Les signaux générés sont ensuite additionnés point à point pour chaque point de la ligne observée.

Le rapport signal/bruit théorique est amélioré dans le rapport de la racine carrée du nombre N de lignes du capteur. Ce nombre peut aller de quelques lignes à une centaine selon les applications (contrôle industriel, observation terrestre, radiographie panoramique dentaire ou mammographie).

De plus, les non-uniformités de sensibilité des pixels d'une même barrette, et les non-uniformités de courant d'obscurité des pixels, sont diminuées par suite du moyennage qui résulte de l'addition des signaux des différentes lignes.

Dans les capteurs d'image à transfert de charges (capteurs CCD), l'addition des signaux point par point se faisait naturellement et sans bruit de lecture en vidant dans une ligne de pixels les charges générées et accumulées dans la ligne de pixels précédente, en synchronisme avec le déplacement relatif de la scène et du capteur. La dernière ligne de pixels, ayant accumulé N fois les charges engendrées par la ligne d'image observée, peut être lue.

La technologie habituelle des capteurs d'image CCD utilise des tensions d'alimentation élevées et consomme une énergie importante ; cette technologie est basée sur l'utilisation de grilles de silicium polycristallin adjacentes et en recouvrement mutuel.

La technologie des capteurs d'image a ensuite évolué vers des capteurs à pixels actifs à transistors, qu'on appellera ci-après capteurs CMOS pour simplifier car ils sont en général réalisés en technologie CMOS (complementary-metal-oxyde-semiconducteur) ; dans ces capteurs CMOS il n'y a plus de transfert de charges de ligne en ligne vers un circuit de lecture ou un registre mais il y a des pixels actifs à transistors qui recueillent des charges électriques photogénérées et les convertissent directement en une tension ou un courant. Les différentes lignes du capteur fournissent donc successivement des tensions ou courants représentant l'éclairement reçu par la ligne. Ces structures ne permettent pas de réaliser des sommations sans bruit de ces courants ou tensions ; il est donc difficile de réaliser un capteur à défilement et à intégration de charges. La technologie de fabrication est cependant simple, elle consomme peu, et elle fonctionne sous basse tension.

Des tentatives ont cependant été faites pour réaliser des capteurs CMOS à défilement et intégration de charges.

On a essayé en particulier d'utiliser des capacités commutées dans lesquelles on intègre des courants successifs reçus, accumulant ainsi sur une même capacité des charges reçues de plusieurs pixels en colonne (US6906749, WO0126382).

On a également proposé de convertir en valeurs numériques les signaux issus d'une ligne de pixels, de sommer la valeur numérique correspondant au pixel de rang j de la ligne dans un registre accumulateur de rang j qui accumule les valeurs numériques correspondant aux pixels de même rang j de N lignes successives (brevet FR2906080).

Dans le brevet FR2906081, on a proposé d'appliquer à la photodiode d'un pixel d'une ligne la tension de sortie d'un pixel d'une ligne précédente, pour y recopier les charges du pixel précédent, avant d'isoler la photodiode et d'intégrer de nouvelles charges dues à la lumière, de sorte qu'à la fin d'un temps d'intégration la photodiode comprend la somme des charges correspondant à la ligne précédente et les nouvelles charges intégrées. Ce fonctionnement induit cependant un bruit de transfert qui détériore le rapport signal/bruit.

Enfin, des solutions utilisant une accumulation de charges à l'intérieur du pixel ont été proposées, par exemple dans la publication de brevet US2008/0217661. Elles utilisent une technologie plus complexe que celle qui est strictement nécessaire pour réaliser des capteurs d'image en technologie CMOS, ou bien elles présentent des pertes lors des transferts de charges.

US6,465,820 décrit un capteur d'image à transfert de charges. Les tentatives pour réaliser un capteur linéaire à défilement et intégration de charges utilisant une technologie plus simple que la technologie CCD habituelle n'ont donc pas donné satisfaction.

Il est important en particulier, lorsqu'on utilise des capteurs à transfert de charges, de bien maîtriser le déversement des charges d'un pixel vers un pixel suivant, en évitant le risque qu'une partie des charges ne parte dans le mauvais sens. On peut y parvenir soit avec des pixels de constitution complexe, soit avec des pixels commandés par trois ou quatre électrodes avec trois ou quatre phases de commande. Il serait souhaitable de pouvoir utiliser des pixels de constitution simple et ayant seulement deux phases de commande identiques pour tous les pixels.

L'invention a pour but de proposer une solution simple pour réaliser des capteurs fonctionnant selon le principe des structures à transfert de charges, utilisant seulement deux phases de commande, et utilisant une technologie compatible avec des circuits de technologie CMOS, notamment une technologie n'utilisant qu'un seul niveau de grille en silicium polycristallin pour les grilles de stockage ou de transfert de charges et non un double niveau de grilles en recouvrement mutuel comme c'est le cas dans les technologies CCD classiques.

Selon l'invention, on propose un capteur d'image à transfert de charges, le capteur comportant N lignes adjacentes de P pixels, les pixels adjacents de même rang appartenant à deux lignes consécutives comprenant chacun une alternance d'au moins une photodiode et une grille de stockage adjacente à la photodiode, les grilles recouvrant une région de couche active d'un premier type de conductivité (en pratique p) et les photodiodes étant formées dans la couche active par une région individuelle d'un deuxième type de conductivité (n) elle-même recouverte par une région superficielle individuelle du premier type (p) reliée à un potentiel de référence de la couche active, caractérisé en ce que les grilles comportent un corps principal et, du côté amont dans le sens du transfert des charges mais pas du côté aval, une série de doigts étroits (20) partant du corps principal en extension vers le côté amont, les extrémités des doigts du côté amont étant adjacentes à une photodiode située en amont de la grille, les doigts étroits étant séparés les uns des autres par des régions d'isolation dopées du premier type de conductivité, plus dopées (et de préférence plus profondes) que les régions superficielles, reliées comme elles au potentiel de référence de la couche active, ces régions d'isolation étant interposées entre le corps principal de la grille et la photodiode de sorte que le corps principal n'est pas adjacent à la photodiode sauf à l'extrémité des doigts.

Les doigts sont suffisamment étroits pour que le potentiel de la couche active sous ces doigts soit influencé par la présence des régions d'isolation dopées de part et d'autre des doigts, de manière que le potentiel sous les doigts soit localement plus faible que sous le corps principal de la grille malgré le fait que les doigts soient portés au même potentiel que le corps principal de la grille.

Par potentiel plus faible, on entend qu'une barrière de potentiel se crée dans la couche active sous les doigts par rapport au potentiel sous le corps principal. Cette notion de barrière de potentiel créée par un potentiel plus faible se réfère au fait que les charges stockées sont des électrons. On supposera en effet pour simplifier (et parce que c'est généralement ainsi dans la pratique) que la couche active est de type p, que les charges photogénérées et stockées sous la grille sont des électrons et non des trous, et par conséquent qu'un potentiel plus bas constitue une barrière de potentiel pour les électrons par rapport à un potentiel plus haut.

Dans tout ce qui suit on considérera que le capteur est réalisé avec une couche active de type p, que les photodiodes stockent des électrons dans des régions individuelles de type n, et que les régions superficielles et les régions dopées qui séparent les doigts étroits sont de type p.

Grâce à cette configuration de grille avec des doigts du côté amont seulement, les charges stockées sous la grille d'un pixel ne peuvent pas s'écouler vers la photodiode située en amont, ni entre les doigts de cette grille à cause de la présence des régions d'isolation, ni sous ces doigts à cause du potentiel induit sous les doigts par ces régions ; elles ne peuvent s'écouler que vers une photodiode en aval de la grille de stockage, par le côté de la grille qui ne comporte pas de doigts ; de ce côté, la grille est directement adjacente à la région superficielle p de la photodiode aval. Inversement, la grille peut recevoir des charges provenant de la photodiode située immédiatement en amont, à travers les doigts dont les extrémités sont directement adjacentes à la photodiode (pourvu que la barrière de potentiel indiquée ci-dessus ne soit pas exagérément haute).

Dans une première réalisation les doigts sont complètement séparés les uns des autres à partir du corps principal de la grille.

Dans une deuxième réalisation, les extrémités des doigts du côté amont sont reliées les unes aux autres par des tronçons d'une bande étroite de grille servant de masque d'alignement pour l'implantation des régions dopées qui constituent les photodiodes (et des régions d'isolation qui séparent les doigts). Dans ce cas presque toutes les régions d'isolation sont délimitées par les bords latéraux de deux doigts voisins, par une portion de corps principal de la grille, et par un tronçon de la bande étroite de grille.

Les régions d'isolation sont de préférence des régions implantées en même temps que les régions de source et drain des transistors qui peuvent être formés sur le même circuit intégré que la matrice de pixels proprement dite ; elles ont donc la même concentration en impuretés et la même profondeur d'implantation que ces régions de source et drain. Le procédé de fabrication en est simplifié.

Le capteur d'image est de préférence un capteur multilinéaire à défilement et intégration de charges mais il peut être aussi un capteur matriciel fournissant une image de NxP points. Dans ce dernier cas, on doit extraire rapidement les charges des NxP pixels après chaque période d'intégration et de préférence interrompre l'illumination du capteur pendant ce transfert.

D'autres caractéristiques et avantages de l'invention apparaîtront à la lecture de la description détaillée qui suit et qui est faite en référence aux dessins annexés dans lesquels :
- la figure 1 représente la structure générale d'un capteur d'image matriciel à transfert de charges ;
- la figure 2 représente une structure de pixels adjacents en colonne constituée par une alternance de grilles de stockage et de photodiodes ;
- la figure 3 représente une vue de dessus d'un pixel selon l'invention ;
- les figures 4 et 5 représentent des coupes verticales selon les lignes IV-IV et V-V de la figure 3 ;
- la figure 6 représente un diagramme des potentiels dans la couche épitaxiale du substrat au-dessous d'un pixel selon l'invention.
- la figure 7 représente une vue de dessus d'une variante de réalisation des grilles du pixel ;
- la figure 8 représente une configuration particulière des doigts.

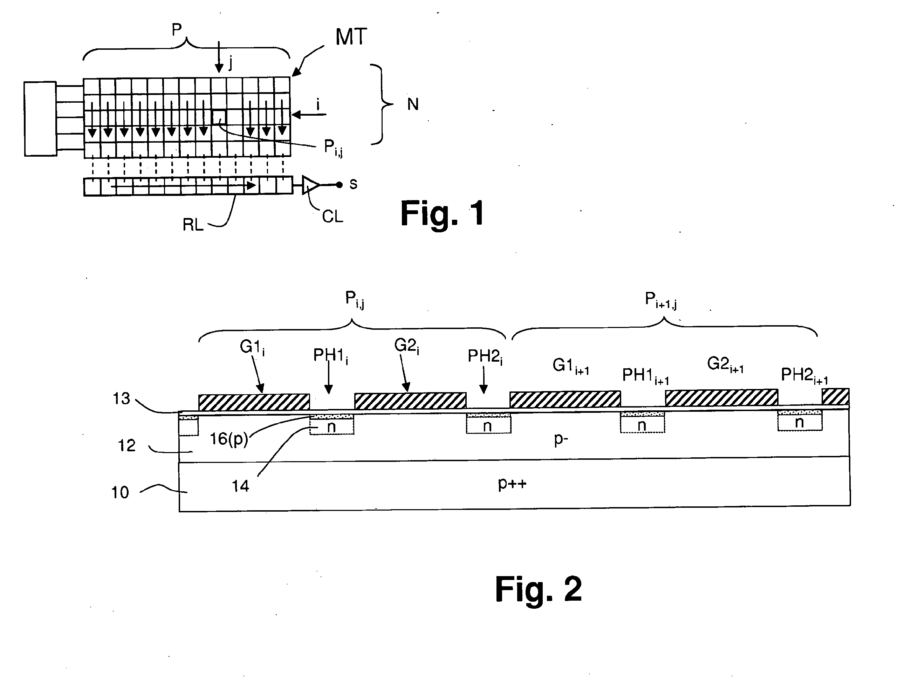

Sur la figure 1, on voit l'architecture générale d'un capteur d'image à transfert de charges. Le capteur comporte une matrice MT de N lignes de P pixels sensibles à la lumière. Les charges résultant de l'éclairement d'un pixel P_{i,j} de rang i en ligne et j en colonne sont intégrées dans le pixel pendant une durée d'intégration T ; puis elles sont transférées dans le pixel de la ligne suivante de rang i+1 en ligne et de même rang j en colonne ; les pixels adjacents dans le sens des colonnes (sens vertical sur la figure) sont agencés en registre à décalage vertical à transfert de charges.

Le capteur peut être un capteur matriciel fournissant des images successives de NxP points d'image ou un capteur multilinéaire fournissant des images linéaires de P points vues et accumulées par les N lignes de pixels.

Dans les deux cas, les pixels en colonne se comportent comme des registres à décalage verticaux mais c'est dans le deuxième cas seulement qu'on accumule dans chaque pixel d'une part les charges provenant d'un pixel précédent et d'autre part les charges photogénérées pendant une durée d'intégration T.

Si le capteur est un capteur matriciel destiné à fournir des images de NxP pixels engendrées pendant une d'intégration T, les charges des NxP pixels sont transférées après la durée T ; le transfert se fait de pixel à pixel en N étapes vers un registre de lecture horizontal RL ou vers une matrice de stockage temporaire non représentée, ou encore vers des circuits de conversion charge/tension affectés chacun à une colonne de pixels ; le registre de lecture RL peut-être un registre à transfert de charges horizontal à P cellules. Pour chaque nouvelle ligne, le registre de lecture RL dirige les charges des P cellules vers un circuit de lecture CL qui les convertit en tension.

Si le capteur est un capteur linéaire à défilement et intégration de charges, on ne lit pas les charges contenues dans les NxP pixels après chaque durée d'intégration T, mais on accumule les charges lues par les N pixels d'une colonne pendant N durées d'intégration successives, en synchronisme avec le défilement de l'image devant le capteur. Chacune des N lignes de pixels voit successivement une même ligne d'image au cours du défilement de l'image par rapport au capteur ; les charges intégrées dans une ligne de rang i, qui correspondent à une ligne d'image observée, sont additionnées dans les pixels de cette ligne aux charges précédemment lues par les i-1 lignes précédentes qui ont vu la même ligne d'image pendant les durées d'intégration précédentes. Au bout de N durées d'intégration, la dernière ligne de pixels contient la somme des charges recueillies par toutes les lignes qui ont vu la même ligne d'image. Cette ligne est lue à la fin de chaque durée T par le registre RL et le circuit de lecture CL.

La vue en coupe de la figure 2 représente une structure générale des pixels d'une même colonne de la matrice dans une configuration où les pixels sont constitués par de simples alternances de grilles et de photodiodes. Cette structure est une structure de principe à partir de laquelle l'invention sera ensuite plus complètement expliquée.

Les pixels sont formés dans un substrat semiconducteur 10 dont la partie supérieure est une couche active semiconductrice épitaxiale peu dopée 12. Dans cet exemple, le substrat est de type p++ fortement dopé, et la couche active épitaxiale est de type p-. Si la couche épitaxiale était de type n, il faudrait inverser tous les types de conductivité, ainsi que les signes des potentiels appliqués aux photodiodes et aux grilles. Le substrat est en principe de même type de conductivité que la couche épitaxiale, mais il pourrait également être de type opposé.

Les colonnes comportent une alternance régulière de photodiodes et de grilles de stockage de charges. On peut considérer par convention qu'un groupe d'une photodiode et une grille de stockage adjacente constitue soit un demi-pixel, soit un pixel entier. Dans la première convention, un pixel comprend deux photodiodes et deux grilles de stockage et tous les pixels de la matrice sont commandés avec des phases identiques d'un pixel à l'autre ; dans la deuxième convention, un pixel comprend une seule photodiode et une seule grille de stockage, mais deux pixels adjacents d'une même colonne sont systématiquement commandés en opposition de phase. Dans ce qui suit on adoptera la première convention et on considérera donc qu'une photodiode et une grille adjacente constituent un demi-pixel, tous les pixels du capteur recevant les mêmes signaux de commande. Deux pixels adjacents P_{i,j} et P_{i+1,j} sont représentés.

Chaque pixel comporte donc deux photodiodes PH1, PH2 et deux grilles de stockage de charges G1, G2 alternées avec les photodiodes. Les photodiodes et grilles sont affectées des indices i et i+1 sur la figure 2 pour les pixels P_{i,j} et P_{i+1,j} respectivement. Les grilles sont des grilles de silicium polycristallin, isolées de la couche épitaxiale 12 par une fine couche isolante 13 (oxyde ou nitrure de silicium). Les photodiodes sont réalisées par un empilement comprenant : la couche épitaxiale 12 de type p (couche active commune pour toutes les photodiodes de tous les pixels), une région individuelle 14 de type n diffusée dans la couche épitaxiale entre deux grilles de transfert, et une région superficielle individuelle 16 de type p, plus dopée que la couche épitaxiale, recouvrant la région individuelle 14. Les électrons générés par l'éclairement pourront s'accumuler dans des puits de potentiel formés à la jonction entre la région n et la couche épitaxiale p.

La deuxième photodiode PH2_{i,j} du pixel P_{j,j} est immédiatement suivie (dans le sens du transfert de charges de la gauche vers la droite) de la première grille de stockage G1_{i+i,j} du pixel suivant Pᵢ₊₁ⱼ, de même que la première grille de transfert G1ᵢ du pixel P_{i,j} est immédiatement précédée de la deuxième photodiode du pixel précédent P_{i-1,j}.

Pour faire fonctionner une succession de pixels constitués d'une manière aussi simple par une alternance de grilles et de photodiodes, il faudrait pouvoir contrôler individuellement les potentiels des photodiodes PH1 et PH2 et les potentiels des grilles G1 et G2 afin de :
- créer dans un pixel, sous une grille ou sous une photodiode, des puits de potentiel pour recevoir des charges nouvellement générées et des charges précédemment accumulées,
- remonter le fond des puits de potentiel à la fin d'une période d'intégration pour provoquer le déversement des charges qu'ils contiennent vers un pixel suivant,
- créer des barrières de potentiel d'un côté du puits mais pas de l'autre, au moment du déversement, pour que le transfert se fasse exclusivement dans un sens.

Il est facile de contrôler le potentiel sous les grilles et d'appliquer des potentiels alternés en opposition de phase (potentiel haut et potentiel bas) aux grilles G1 et G2 ; mais il est difficile de faire varier le potentiel des photodiodes, d'autant plus qu'il faut que le potentiel des régions superficielles 16 de type p reste au potentiel de référence de la couche active 12 pendant l'intégration de charges. En conséquence de cette difficulté, il est difficile avec la structure de la figure 2 d'imposer un sens de transfert aux charges photogénérées.

C'est pourquoi l'invention propose que les pixels aient une configuration particulière qui assure une directivité du transfert sans avoir besoin d'agir sur le potentiel des régions superficielles 16 de type p lors du transfert, et sans prévoir d'électrodes supplémentaires et de phases de commande supplémentaires dans les pixels.

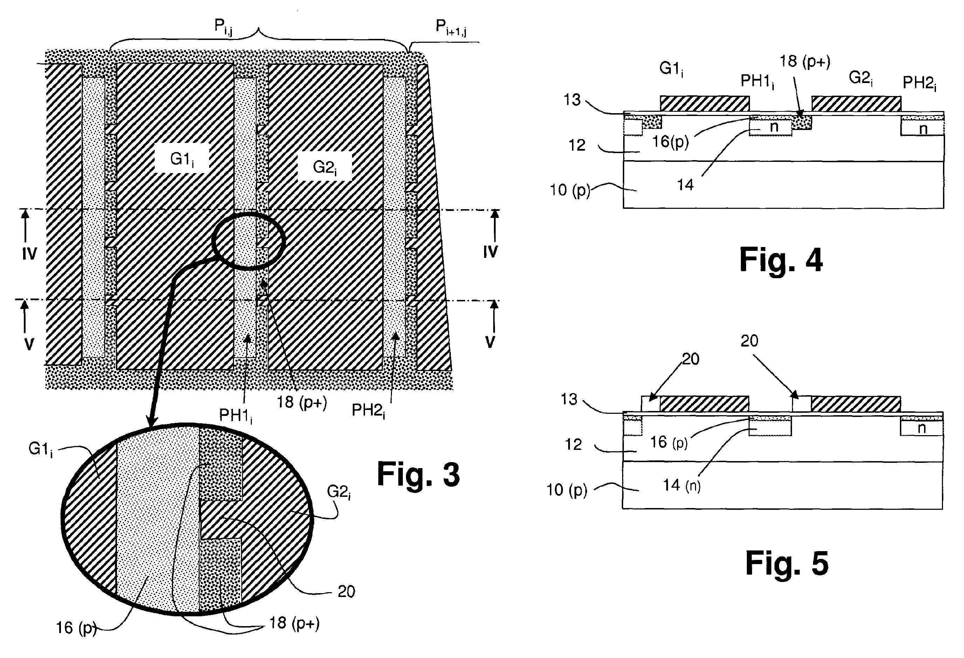

Cette configuration est représentée à la figure 3 (vue de dessus d'un pixel P_{i,j}) la figure 4 (vue en coupe selon la ligne IV-IV de la figure 3), et figure 5 (vue en coupe selon la ligne V-V de la figure 3).

Le pixel comprend encore une alternance, de grilles de stockage et de photodiodes dans les mêmes conditions que celles de la figure 2. Il y a au moins une grille de stockage et une photodiode par pixel, et on adoptera la même convention que précédemment, à savoir qu'un pixel comprend deux demi-pixels ayant chacun une grille de stockage adjacente à une photodiode.

En vue de dessus, les grilles des pixels selon l'invention sont dissymétriques ; leur côté tourné vers l'aval dans le sens du transfert des charges est différent du côté tourné vers l'amont. L'amont est situé sur la gauche, l'aval vers la droite sur la figure 3.

Du côté amont, chaque grille G1ᵢ, G2ᵢ comporte une série de doigts étroits 20 en extension vers l'amont à partir d'une surface principale rectangulaire ou corps principal de la grille. Du côté aval les grilles ne comportent pas de doigts étroits.

La coupe de la figure 4 est faite là où il n'y a pas de doigts ; celle de la figure 5 est faite là où il y a des doigts.

Les photodiodes sont définies par la région dopée 14 de type N recouverte d'une zone superficielle 16 de type p portée au potentiel de la couche active 12 (et du substrat 10) ; elles sont adjacentes à la grille située en aval de la photodiode à l'extrémité des doigts 20 de cette grille ; mais elles ne sont pas adjacentes à la surface principale de la grille ; en dehors de l'extrémité des doigts étroits, les photodiodes ne sont pas adjacentes à la grille et elles en sont séparées par des régions d'isolation 18 dopées de type p+, plus dopées que les régions superficielles 16 qui recouvrent les photodiodes. Si les régions superficielles 16 sont très peu profondes comme on le souhaite pour améliorer la sensibilité dans le bleu, alors les régions 18 sont de préférence plus profondes que les régions 16.

Du côté aval de la grille, les photodiodes sont adjacentes à la surface principale de la grille.

Cette disposition d'une grille par rapport à une photodiode s'applique pour une grille et une photodiode adjacentes appartenant au même pixel aussi bien que pour une grille et une photodiode adjacentes appartenant à deux pixels voisins.

Les régions d'isolation dopées 18 viennent à proximité immédiate des doigts de part et d'autre de ceux-ci. Elles sont portées au potentiel de référence en profondeur de la couche active 12, c'est-à-dire (si le substrat est de même type que la couche active) au potentiel du substrat 10 qui est un potentiel de référence pour l'ensemble de la matrice de pixels. Cette connexion des régions 18 au potentiel du substrat se fait ici tout naturellement puisque les régions 18 sont des régions p+ diffusées dans une couche active p elle-même en contact avec le substrat p+.

Dans la pratique, si le capteur comporte des circuits à transistors PMOS en dehors de la matrice de pixels, les régions d'isolation p+ 18 peuvent être faites en même temps que les régions de source et de drain de type p+ de ces transistors. Elles ont donc la même profondeur et la même concentration (toutes deux plus élevées que celles de la région superficielle). Cependant, une implantation spécifique peut être prévue si on préfère ajuster la profondeur et la concentration des régions 18 indépendamment des choix faits pour les régions de source et drain de transistors. Ces régions 18 peuvent également être faites en même temps que d'autres régions p+, notamment celles qui servent à isoler latéralement les uns des autres les pixels appartenant à des colonnes différentes, comme cela a été représenté sur la figure 3.

La largeur des doigts étroits 20 dans le sens perpendiculaire au transfert de charges d'une photodiode vers une grille de stockage est suffisamment faible et le dopage des régions 18 est suffisamment fort pour que le potentiel de la partie supérieure de la couche active épitaxiale 12 sous les doigts 20 soit influencé par la présence des régions 18 de part et d'autre du doigt. En d'autres mots, sous la partie principale de la grille, le potentiel dans la couche active est bien sûr influencé par le potentiel électrique appliqué à la grille, mais sous les doigts il est différent à cause de la présence des régions 18 situées de part et d'autre du doigt et à cause de l'étroitesse des doigts, bien que les doigts soient portés au même potentiel que le corps principal de la grille.

Sur la figure 4 on voit les régions 18 mais non les doigts 20 puisque le plan de coupe ne passe pas par les doigts ; sur la figure 5 on voit les doigts mais pas les régions 18 puisqu'il n'y a pas de région 18 entre une photodiode et une grille le long de la ligne de coupe.

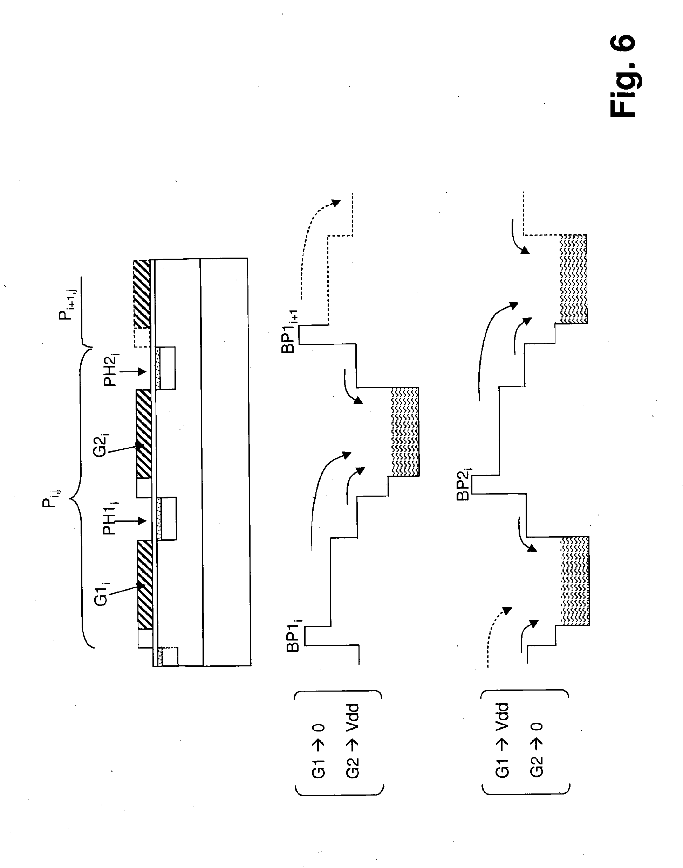

La figure 6 représente un diagramme de potentiels à l'intérieur de la couche active, à une profondeur où se situe le stockage et le transfert de charges, c'est-à-dire légèrement au-dessous de la surface supérieure de la couche active. Cette figure est tracée dans le même plan de coupe qu'à la figure 5, c'est-à-dire là où il y a des doigts. Le transfert de charges ne s'effectue que sous les doigts en raison du fait que les régions 18 p+ portées au potentiel de référence du substrat créent des barrières de potentiel élevées empêchant tout transfert de charges d'une photodiode vers une grille ou réciproquement.

Le capteur fonctionne avec deux phases seulement. Toutes les grilles G1 sont connectées en même temps et reçoivent alternativement un potentiel bas qui est en principe le potentiel de référence 0, et un potentiel haut qui est en principe le potentiel d'alimentation Vdd de la matrice de pixels. Vdd peut être de 5 volts. Toutes les grilles G2 sont connectées entre elles pour recevoir alternativement ce potentiel bas et ce potentiel haut, mais en opposition de phase avec les grilles G1.

Deux tracés de potentiel sont représentés sur la figure 6 ; l'un correspond à la première phase (grilles G1 au potentiel bas, grilles G2 au potentiel haut) ; l'autre correspond à la deuxième phase (G1 au potentiel haut, G2 au potentiel bas). La durée de chacune des deux phases est la moitié de la période d'intégration T correspondant à l'observation d'une ligne d'image par une ligne de pixels.

Conformément à la convention habituelle, les potentiels croissants sont dirigés vers le bas pour bien faire apparaître les puits de potentiel et les barrières de potentiel pour les électrons.

Dans la première phase de durée T, le potentiel induit sous les grilles G2 à Vdd est plus haut que celui des photodiodes adjacentes et plus haut que celui qui est induit sous les grilles G1 ; les charges qui étaient stockées sous la grille de stockage G1ᵢ à la fin de la durée d'intégration précédente se déversent, au début de la nouvelle période d'intégration, sous la grille de stockage G2ᵢ à travers la photodiode PH1ᵢ, en raison du passage de la grille G1ᵢ à 0v, et à travers les doigts de la grille G2ᵢ ; les charges ne passent pas à travers les régions d'isolation 18. La légère baisse du potentiel sous les doigts 20 de la grille G1ᵢ, due à la proximité des régions 18 de part et d'autre des doigts, crée une barrière de potentiel BP1ᵢ en amont de la grille G1ᵢ ; cette barrière BP1ᵢ empêche que les charges situées sous la grille G1ᵢ ne partent vers la gauche au début de la phase. Un transfert total de charges se fait vers la droite, des grilles G1 aux grilles G2, au début de la première phase. Puis, les charges générées par la lumière dans la photodiode PH1ᵢ, mais aussi celles qui sont générées dans la photodiode PH2ᵢ se déversent sous la grille de stockage G2ᵢ en raison du puits de potentiel créé entre les deux photodiodes par l'application du potentiel Vdd sur la grille G2ᵢ ; les charges générées par la photodiode PH1ᵢ située en amont de la grille G2ᵢ, se déversent à travers les doigts étroits de celle-ci, la barrière de potentiel induite localement sous les doigts de la grille G2ᵢ étant conçue pour ne pas passer au-dessous du potentiel dans la photodiode ; ce dernier potentiel est défini par les profils de dopage dans la photodiode, sachant que la partie superficielle 16 est maintenue au potentiel de référence zéro.

Dans la deuxième phase, ce sont les grilles G1 qui passent à Vdd avant que les grilles G2 ne passent à 0. Le potentiel induit sous les grilles G1 devient plus bas que celui des photodiodes et que celui qui est induit sous les grilles G2 ; les charges qui étaient sous la grille de stockage G2ᵢ à la fin de la première phase se déversent, au début de la nouvelle période d'intégration, sous la grille de stockage G1ᵢ₊₁ du pixel suivant, en passant à travers la photodiode PH2ᵢ qui est à un potentiel intermédiaire, et à travers les doigts de cette grille G1ᵢ₊₁. La légère baisse du potentiel sous les doigts 20, due à la proximité des régions 18 de part et d'autre des doigts de la grille G2ᵢ crée une barrière de potentiel BP2ᵢ en amont de la grille G2ᵢ ; cette barrière empêche que les charges situées sous la grille G2ᵢ ne partent vers la gauche au début de la phase. Un transfert total de charges se fait là encore vers la droite, des grilles G2 vers les grilles G1. Puis, les charges générées par la lumière dans la photodiode PH1ᵢ se déversent sous la grille de stockage G1ᵢ ; les charges générées au cours de la deuxième phase par l'autre photodiode PH2ᵢ se déversent dans la première grille du pixel suivant à travers les doigts de celle-ci.

On a donc bien à la fois un transfert unidirectionnel des charges vers la droite, et une sommation des charges accumulées dans un pixel précédent avec les charges générées dans le pixel courant.

Les simulations effectuées montrent que la hauteur de la barrière de potentiel BP1ᵢ, BP2ᵢ, varie fortement avec la largeur des doigts étroits 20 ; typiquement elle peut varier de 0,5 volt à 2,5 volts pour des largeurs de doigts variant de 0,7 micromètre à 0,3 micromètres, largeurs qui sont facilement réalisables ; ces valeurs sont indicatives car elles dépendent de la technologie de gravure et des niveaux d'implantation utilisés. La hauteur de la barrière de potentiel ne doit pas cependant être trop élevée pour ne pas empêcher le déversement de charges de la photodiode vers la grille située en aval pendant la durée d'intégration ; en effet la barrière formée entre la région située sous le corps principal de la grille et la région située sous les doigts existe également lorsque les grilles sont au potentiel Vdd et il ne faut pas que cette barrière dépasse le niveau de potentiel de référence des photodiodes. Une largeur de doigts inférieure ou égale à 0,4 micromètre est bien adaptée.

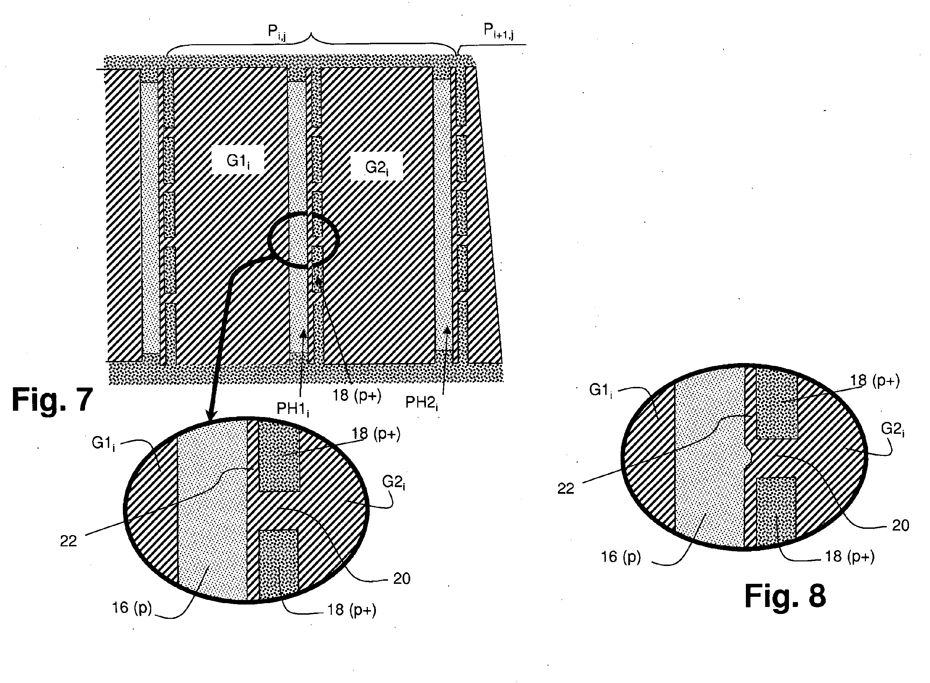

Dans une variante de réalisation représentée à la figure 7 en vue de dessus, les extrémités des doigts du côté amont de la grille sont reliées les unes aux autres par des tronçons 22 d'une bande étroite de grille de silicium polycristallin 22 servant de masque d'alignement pour l'implantation des régions dopées des photodiodes et des régions d'isolation 18. Les régions 18 sont alors délimitées par les deux doigts, par une portion de corps principal de la grille, et par une portion de la bande étroite de grille. La surface des photodiodes est alors mieux contrôlée, ce qui est important pour une meilleure uniformité de réponse des pixels de la matrice. La largeur des tronçons 22 de bande étroite de préférence inférieure à la largeur des doigts pour que l'influence des régions 18 sur le potentiel dans la couche active s'exerce aussi sous cette bande. La forme de l'extrémité du doigt peut comporter un renfoncement à l'endroit où la bande étroite rejoint le doigt, comme indiqué sur la figure 8, pour éviter des risques de création de poches de potentiel indésirables sous les doigts, poches dans lesquelles des charges pourraient rester piégées lors des transferts.

La longueur des doigts dans le sens du transfert peut être sensiblement égale à leur largeur.

On notera que la constitution des pixels avec une photodiode entre deux grilles de stockage permet d'avoir une bonne réponse dans les longueurs d'onde bleues, la photodiode n'étant pas masquée par une grille qui absorbe le bleu.

Le capteur peut être un capteur aminci éclairé par la face arrière, et on peut alors augmenter la profondeur d'implantation des régions superficielles des photodiodes sans réduire la sensibilité dans le bleu. Dans ce cas, la profondeur des implantations des régions d'isolation 18 n'est pas nécessairement supérieure à la profondeur des régions superficielles 16. D'ailleurs, pour un capteur destiné à prendre une image dans le rouge, même si le capteur n'est pas aminci, on peut prévoir que les régions superficielles 16 sont aussi profondes que les régions d'isolation 18 car leur profondeur a alors peu de conséquences sur la sensibilité du capteur..

Dans ce qui précède, on a considéré que les charges se déversent en bout de colonne dans un registre de lecture à transfert de charges horizontal (registre RL de la figure 1). On pourrait aussi prévoir que ce registre est remplacé par une série de noeuds de stockage de charges et de circuits de conversion charge-tension (un noeud de stockage de charges et un circuit de conversion étant associés à chaque colonne de la matrice). Le circuit de conversion comprend quelques transistors, analogues aux transistors d'un pixel actif de capteur de technologie CMOS, parmi lesquels un transistor suiveur et un transistor de réinitialisation. Le circuit de conversion est alors de préférence associé à un circuit de double échantillonnage corrélé qui échantillonne d'abord un niveau de potentiel de réinitialisation au moment de la réinitialisation du potentiel du noeud de stockage de charges, puis un niveau de signal utile après déversement de charges de la dernière ligne de la matrice dans les noeuds de stockage de charges. La différence des deux échantillons est convertie par un convertisseur analogique-numérique. Un convertisseur élémentaire peut être prévu pour chaque colonne de pixels ou bien un convertisseur global effectue séquentiellement la conversion pour chacune des colonnes.

## Revendications

1. Capteur d'image à transfert de charges, le capteur comportant N lignes adjacentes de P pixels, les pixels adjacents de même rang appartenant à deux lignes consécutives comprenant chacun une alternance d'au moins une photodiode (PH1ᵢ, PH2ᵢ) et une grille de stockage (G1_{i,} G2ᵢ) adjacente à la photodiode, les grilles recouvrant une région de couche active (12) d'un premier type de conductivité et les photodiodes étant formées dans la couche active par une région individuelle d'un deuxième type de conductivité (14) elle-même recouverte par une région superficielle individuelle du premier type (16) reliée à un potentiel de référence de la couche active, **caractérisé en ce que** les grilles comportent un corps principal et, du côté amont dans le sens du transfert des charges mais pas du côté aval, une série de doigts étroits (20) partant du corps principal en extension vers le côté amont, les extrémités des doigts du côté amont étant adjacentes à une photodiode située en amont de la grille, les doigts étroits étant séparés les uns des autres par des régions d'isolation (18) dopées du premier type de conductivité, plus dopées que les régions superficielles, reliées comme elles au potentiel de référence de la couche active, ces régions d'isolation étant interposées entre le corps principal de la grille et la photodiode.

2. Capteur d'image selon la revendication 1, **caractérisé en ce que** les régions d'isolation (18) sont plus profondes que les régions superficielles (16) des photodiodes.

3. Capteur d'image selon l'une des revendications 1 et 2, **caractérisé en ce que** les doigts sont complètement séparés les uns des autres à partir du corps principal de la grille.

4. Capteur d'image selon l'une des revendications 1 et 2, **caractérisé en ce que** les extrémités des doigts du côté amont sont reliées les unes aux autres par des tronçons (22) d'une étroite bande de grille servant de masque d'alignement pour l'implantation des régions dopées constituant les photodiodes et des régions d'isolation (18).

5. Capteur selon la revendication 4, **caractérisé en ce que** les régions d'isolation sont délimitées par les deux doigts, par une portion de corps principal de la grille, et par un tronçon de la bande étroite de grille.

6. Capteur selon l'une des revendications1 à 5, **caractérisé en ce que** les régions d'isolation du premier type de conductivité qui séparent les doigts sont des régions implantées avec la même concentration et la même profondeur que des régions de source et drain de transistors formés sur le même circuit intégré que la matrice de pixels.

7. Capteur d'image selon l'une des revendications 1 à 6, **caractérisé en ce qu'**il est un capteur à défilement et intégration de charges, en vue d'une observation d'une même ligne d'image successivement par plusieurs lignes de pixels avec une sommation des charges électriques générées par un point d'image dans les pixels de même rang des différentes lignes, les charges générées par l'éclairement d'un pixel de rang i pendant une durée d'intégration s'additionnant aux charges reçues du pixel de rang précédent au début de cette durée.

8. Capteur d'image selon l'une des revendications 1 à 7, **caractérisé en ce qu'**il comporte une série de noeuds de stockage de charges et de circuits de conversion charge-tension, chaque circuit de conversion comprenant quelques transistors parmi lesquels un transistor suiveur et un transistor de réinitialisation.

9. Capteur d'image selon la revendication 8, **caractérisé en ce que** le circuit de conversion est associé à un circuit de double échantillonnage corrélé qui échantillonne d'abord un niveau de réinitialisation au moment de la réinitialisation du potentiel du noeud de stockage de charges, puis un niveau de signal utile après déversement dé charges de la dernière ligne de la matrice dans les noeuds de stockage de charges.

## Patentansprüche

1. Ladungsübertragungsbildsensor, wobei der Sensor N benachbarte Reihen von P Pixeln umfasst, wobei die benachbarten Pixel desselben Rangs zu zwei aufeinander folgenden Reihen gehören, die jeweils abwechselnd wenigstens eine Fotodiode (PH1ᵢ, PH2ᵢ) und ein Speichergitter (G1ᵢ, G2ᵢ) neben der Fotodiode umfassen, wobei die Gitter eine aktive Schichtregion (12) eines ersten Leitfähigkeitstyps bedecken und die Fotodioden in der aktiven Schicht durch eine individuelle Region eines zweiten Leitfähigkeitstyps (14) gebildet werden, die wiederum durch eine individuelle Oberflächenregion des ersten Typs (16) bedeckt ist, die mit einem Referenzpotential der aktiven Schicht verbunden ist, **dadurch gekennzeichnet, dass** die Gitter einen Hauptkörper umfassen und auf der stromaufwärtigen Seite in Ladungsübertragungsrichtung, aber nicht auf der stromabwärtigen Seite, eine Serie von schmalen Fingern (20) umfassen, die sich vom Hauptkörper in Verlängerung zur stromaufwärtigen Seite erstrecken, wobei sich die Enden der Finger auf der stromaufwärtigen Seite neben einer Fotodiode stromaufwärts von dem Gitter befinden, wobei die schmalen Finger durch Isolationsregionen (18) voneinander getrennt sind, die mit dem ersten Leitfähigkeitstyp dotiert sind, stärker dotiert als die Oberflächenregionen, wie diese verbunden mit dem Referenzpotential der aktiven Schicht, wobei sich diese Isolationsregionen zwischen dem Hauptkörper des Gitters und der Fotodiode befinden.

2. Bildsensor nach Anspruch 1, **dadurch gekennzeichnet, dass** die Isolationsregionen (18) tiefer sind als die Oberflächenregionen (16) der Fotodioden.

3. Bildsensor nach einem der Ansprüche 1 und 2, **dadurch gekennzeichnet, dass** die Finger ab dem Hauptkörper des Gitters vollständig voneinander getrennt sind.

4. Bildsensor nach einem der Ansprüche 1 und 2, **dadurch gekennzeichnet, dass** die Enden der Finger auf der stromaufwärtigen Seite miteinander durch Sektionen (22) eines schmalen Gitterbandes verbunden sind, das als Ausrichtungsmaske für die Implantation der dotierten Regionen dient, die die Fotodioden und die Isolationsregionen (18) bilden.

5. Sensor nach Anspruch 4, **dadurch gekennzeichnet, dass** die Isolationsregionen durch die beiden Finger, durch einen Hauptkörperabschnitt des Gitters und durch eine Sektion des schmalen Gitterbandes begrenzt werden.

6. Sensor nach einem der Ansprüche 1 bis 5, **dadurch gekennzeichnet, dass** die die Finger trennenden Isolationsregionen des ersten Leitfähigkeitstyps implantierte Regionen mit derselben Konzentration und derselben Tiefe sind wie - Source- und Drain-Regionen von Transistoren, die auf derselben integrierten Schaltung ausgebildet sind wie die Pixelmatrix.

7. Bildsensor nach einem der Ansprüche 1 bis 6, **dadurch gekennzeichnet, dass** es sich um einen Ladungsentfaltungs- und -integrationssensor handelt, im Hinblick auf eine Beobachtung einer selben Bildreihe sukzessiv durch mehrere Pixelreihen mit einer Summierung von elektrischen Ladungen, die durch einen Bildpunkt in den Pixeln desselben Rangs der verschiedenen Reihen erzeugt werden, wobei sich die durch Beleuchten eines Pixels von Rang i erzeugten Ladungen während einer Integrationsdauer zu den Ladungen addieren, die vom Pixel des vorherigen Rangs am Anfang dieser Dauer empfangen wurden.

8. Bildsensor nach einem der Ansprüche 1 bis 7, **dadurch gekennzeichnet, dass** er eine Serie von Ladungsspeicherknoten und von Ladung-Spannung-Wandlerschaltungen umfasst, wobei jede Wandlerschaltung einige Transistoren umfasst, darunter einen Folgertransistor und einen Rückstelltransistor.

9. Bildsensor nach Anspruch 8, **dadurch gekennzeichnet, dass** die Wandlerschaltung mit einer korrelierten Doppelabtastschaltung assoziiert ist, die zunächst einen Rückstellpegel im Moment des Rückstellens des Potentials des Ladungsspeicherknotens, dann einen Nutzsignalpegel nach dem Kippen von Ladungen der letzten Reihe der Matrix in den Ladungsspeicherknoten abtastet.

## Claims

1. A charge transfer image sensor, the sensor comprising N adjacent rows of P pixels, the adjacent pixels of same rank belonging to two consecutive rows each comprising an alternation of at least one photodiode (PH1ᵢ, PH2ᵢ) and one storage gate (G1ᵢ, G2ᵢ) adjacent to the photodiode, the gates covering an active layer region (12) of a first type of conductivity and the photodiodes being formed within the active layer by an individual region of a second type of conductivity (14), itself covered by an individual surface region of the first type (16) connected to a reference potential of the active layer, **characterized in that** the gates comprise a main body and, on the upstream side in the direction of the transfer of the charges but not on the downstream side, a series of narrow fingers (20) extending from the main body toward the upstream side, the ends of the fingers on the upstream side being adjacent to a photodiode situated upstream of the gate, the narrow fingers being separated from one another by doped insulating regions (18) of the first type of conductivity, with a higher doping than the surface regions, connected, as they are, to the reference potential of the active layer, these insulating regions being interposed between the main body of the gate and the photodiode.

2. The image sensor as claimed in claim 1, **characterized in that** the insulating regions (18) are deeper than the surface regions (16) of the photodiodes.

3. The image sensor as claimed in either of claims 1 and 2, **characterized in that** the fingers are completely separated from one another starting from the main body of the gate.

4. The image sensor as claimed in either of claims 1 and 2, **characterized in that** the ends of the fingers on the upstream side are connected to one another by sections (22) of a narrow strip of gate used as an alignment mask for the implantation of the doped regions forming the photodiodes and of the insulating regions (18).

5. The sensor as claimed in claim 4, **characterized in that** the insulating regions are bounded by the two fingers, by a portion of the main body of the gate, and by a section of the narrow strip of gate.

6. The sensor as claimed in one of claims 1 to 5, **characterized in that** the insulating regions of the first type of conductivity which separate the fingers are regions implanted with the same concentration and the same depth as transistor source and drain regions formed on the same integrated circuit as the matrix of pixels.

7. The image sensor as claimed in one of claims 1 to 6, **characterized in that** it is a scanning sensor with charge integration, with a view to an observation of the same image line successively by several rows of pixels with a summation of the electrical charges generated by an image dot in the pixels of same rank of the various rows, the charges generated by the illumination of a pixel of rank i over an integration time being added to the charges received from the pixel of preceding rank at the start of this period.

8. The image sensor as claimed in one of claims 1 to 7, **characterized in that** it comprises a series of charge storage nodes and of charge-voltage conversion circuits, each conversion circuit comprising a few transistors amongst which are a follower transistor and a reset transistor.

9. The image sensor as claimed in claim 8, **characterized in that** the conversion circuit is associated with a correlated double-sampling circuit which firstly samples a reset level at the time of the reset of the potential of the charge storage node, then a useful signal level after transfer of charges from the last row of the matrix into the charge storage nodes.
